(19) Europäisches Patentamt
European Patent Office
Office européen des brevets

(11) **EP 1 835 619 B1**

(12) **FASCICULE DE BREVET EUROPEEN**

(45) Date de publication et mention
de la délivrance du brevet:
**25.08.2010 Bulletin 2010/34**

(51) Int Cl.:
*H03K 7/08* *(2006.01)*  *H03F 3/217* *(2006.01)*

(21) Numéro de dépôt: **07290307.3**

(22) Date de dépôt: **12.03.2007**

(54) **Générateur électronique de signal à rapport cyclique modulé, compensé des variations de sa tension d'alimentation**

Elektronischer Signalgeber mit moduliertem Tastverhältnis, bei dem die Schwankungen seiner Spannung kompensiert sind

Electronic signal generator with modulated duty factor, compensated by variations of its input voltage

(84) Etats contractants désignés:
**DE FR GB IT**

(30) Priorité: **13.03.2006 FR 0602189**

(43) Date de publication de la demande:
**19.09.2007 Bulletin 2007/38**

(73) Titulaire: **STMicroelectronics SA**
**92120 Montrouge (FR)**

(72) Inventeurs:
• **Giraud, Olivier**
**38250 Villard de Lans (FR)**

• **Petigny, Roger**
**38410 St. Martin d'Uriage (FR)**
• **Marguery, Philippe**
**38320 Poisat (FR)**

(74) Mandataire: **Bentz, Jean-Paul et al**
**Novagraaf Technologies**
**122 Rue Edouard Vaillant**
**92593 Levallois-Perret Cedex (FR)**

(56) Documents cités:
**EP-A- 0 817 371   EP-A- 1 003 279**
**US-A- 4 554 512   US-A1- 2005 017 799**

**Description**

L'invention concerne, de façon générale, les techniques de pilotage des amplificateurs de classe D.

Plus précisément, l'invention concerne un générateur électronique, propre à fournir au moins un premier signal de sortie présentant un rapport cyclique modulé à une fréquence de base et notamment adapté à alimenter un transducteur audio, ce générateur comprenant au moins : un premier circuit de formatage présentant une entrée recevant un premier signal d'entrée, et une sortie délivrant un premier signal intermédiaire présentant un rapport cyclique modulé à la fréquence de base; et au moins un premier amplificateur de classe D alimenté par une tension d'alimentation, relié à la sortie du premier circuit de formatage, et fournissant, en tant que premier signal de sortie du générateur, un signal évoluant en fonction du premier signal intermédiaire et d'amplitude liée à la tension d'alimentation, ledit premier circuit de formatage comprenant au moins un intégrateur élaborant un signal d'intégration, et un comparateur élaborant le premier signal intermédiaire par comparaison du signal d'intégration avec un signal de référence.

Pour mémoire, on rappelle qu'un signal à rapport cyclique modulé à une fréquence de base est un signal dont l'amplitude n'adopte, à chaque instant, que l'un ou l'autre de deux niveaux logiques différents respectivement haut et bas, la valeur véhiculée par ce signal étant codée dans le "rapport cyclique" qui désigne, sur chaque période de la fréquence de base, la fraction de cette période pendant laquelle le signal est au niveau haut.

Les générateurs de signaux à modulation de rapport cyclique sont bien connus dans l'art antérieur et sont notamment utilisés dans la téléphonie mobile pour piloter les haut-parleurs des récepteurs.

Dans cette application comme dans d'autres, il est généralement souhaitable de maximiser l'énergie du signal de sortie produit par le générateur et d'optimiser la dynamique de ce signal.

Cependant, si l'information véhiculée dans un signal à rapport cyclique modulé est exclusivement et idéalement codée dans ce rapport cyclique, en revanche, l'énergie véhiculée par ce signal dépend aussi de l'amplitude de ce signal, c'est-à-dire de la différence entre le niveau haut et le niveau bas du signal.

Ainsi, dans le cas où la tension d'alimentation de l'amplificateur de classe D est fournie par une batterie, les variations de la puissance disponible à partir de celle-ci peuvent conduire à une variation de l'amplitude du signal de sortie, et donc à une baisse sensible des performances de la charge pilotée par le générateur, par exemple du haut-parleur.

Dans ce contexte, l'invention a pour but de proposer un générateur de signal modulé en rapport cyclique qui permette de surmonter ce défaut.

A cette fin, le générateur de l'invention, par ailleurs conforme à la définition générique qu'en donne le préambule ci-dessus, est essentiellement caractérisé en ce que l'intégrateur est conçu pour intégrer la différence entre deux signaux composites, en ce que l'un des signaux composites est constitué par les premiers signaux d'entrée et de sortie pondérés par des facteurs d'amplification respectifs dont le rapport correspond à un premier gain, en ce que l'autre signal composite est constitué d'une première et d'une seconde tensions de décalage respectivement égales à la moitié de l'amplitude maximale du premier signal d'entrée et à la moitié de la tension d'alimentation, ces tensions de décalage étant pondérées par des facteurs d'amplification respectifs dont le rapport correspond au premier gain, et en ce que le signal de référence fourni au comparateur présente une valeur moyenne égale à la moitié de la tension d'alimentation.

Pour augmenter la puissance de sortie sans avoir à augmenter la tension d'alimentation, il est judicieux de prévoir que ce générateur puisse également fournir un second signal de sortie présentant un rapport cyclique modulé à la fréquence de base et notamment adapté à alimenter le transducteur audio recevant également le premier signal de sortie, que ce générateur comprenne à cette fin un second circuit de formatage présentant une entrée recevant un second signal d'entrée, et une sortie délivrant un second signal intermédiaire présentant un rapport cyclique modulé à la fréquence de base; et un second amplificateur de classe D alimenté par la tension d'alimentation, relié à la sortie du second circuit de formatage, et fournissant, en tant que second signal de sortie du générateur, un signal évoluant en fonction du second signal intermédiaire et d'amplitude liée à la tension d'alimentation, que ledit second circuit de formatage soit équivalent dans sa structure et sa fonction au premier circuit de formatage, utilise ledit signal de référence et lesdites tensions de décalage pondérées pour présenter un rapport d'amplification correspondant audit premier gain, et applique au second signal d'entrée, pour l'obtention du second signal intermédiaire, une fonction de transfert identique à celle que le premier circuit de formatage applique au premier signal d'entrée pour l'obtention du premier signal intermédiaire, que les premier et second amplificateurs forment des moitiés respectives symétriques d'un même pont d'amplification de classe D conformé en H, et que la somme des premier et second signaux d'entrée présente une valeur moyenne constante.

Quel que soit son mode de réalisation choisi, ce générateur peut fonctionner en admettant, pour premier signal d'entrée, un signal sinusoïdal de valeur moyenne égale à la moitié de la tension d'alimentation, auquel cas le signal de référence est alors constitué par un signal triangulaire unipolaire.

Néanmoins, ce générateur peut aussi fonctionner en admettant pour premier signal d'entrée un signal présentant une amplitude calibrée et un rapport cyclique modulé à la fréquence de base, auquel cas le signal de référence est alors constitué par un signal continu égal à la moitié de la tension d'alimentation.

Dans ce dernier cas, et lorsque le générateur produit deux signaux de sortie, il est avantageux de faire en sorte que le second signal d'entrée soit un signal présentant la même amplitude calibrée que le premier signal d'entrée, un rapport cyclique modulé à la fréquence de base et complémentaire à 1 du rapport cyclique du premier signal d'entrée, et un déphasage de 180 degrés par rapport au premier signal d'entrée, ce dont il résulte que les premier et second signaux de sortie sont des signaux mutuellement déphasés de 180 degrés, présentant une même amplitude liée à la tension d'alimentation, et des rapports cycliques respectifs modulés à la fréquence de base et complémentaires à 1 l'un de l'autre, le rapport cyclique de chaque signal de sortie étant égal au rapport cyclique du signal d'entrée correspondant corrigé de toute éventuelle variation du rapport entre l'amplitude de la tension d'alimentation et l'amplitude de la tension calibrée.

D'autres caractéristiques et avantages de l'invention ressortiront clairement de la description qui en est faite ci-après, à titre indicatif et nullement limitatif, en référence aux dessins annexés, dans lesquels :

- la figure 1 est un schéma général d'un générateur conforme à l'invention et fournissant deux signaux de sortie, ce schéma représentant en détail les deux amplificateurs de classe D;
- la figure 2 est un autre schéma général d'un générateur conforme à l'invention et fournissant deux signaux de sortie, ce schéma représentant en détail les deux circuits de formatage;
- la figure 3 est un diagramme représentant deux signaux d'entrée susceptible d'être traités par le générateur illustré aux figures 1 et 2; et
- les figures 4A à 4I sont des diagrammes représentant divers signaux illustrant le fonctionnement du générateur représenté aux figures 1 et 2.

Comme annoncé précédemment, l'invention concerne un générateur électronique, propre à fournir un ou deux signaux de sortie, tels que Vs1 de Vs2, présentant chacun un rapport cyclique modulé à une fréquence de base 1/T, ce générateur étant notamment adapté à alimenter un transducteur audio HP.

Ce générateur comprend au moins un ou deux circuits de formatage tels que F1 et F2, et un ou deux amplificateurs de classe D, tels que A1 et A2.

Dans la mesure où le doublement symétrique d'un schéma électronique est une technique bien connue de l'homme du métier, le générateur de l'invention sera décrit en référence aux figures dans sa version la plus complète, étant entendu néanmoins qu'il pourrait être réalisé sans recourir au circuit de formatage F2 ni à l'amplificateur A2.

Chacun des circuits de formatage F1 et F2 présente une entrée correspondante 10 ou 20, recevant un signal d'entrée correspondant Ve1 ou Ve2.

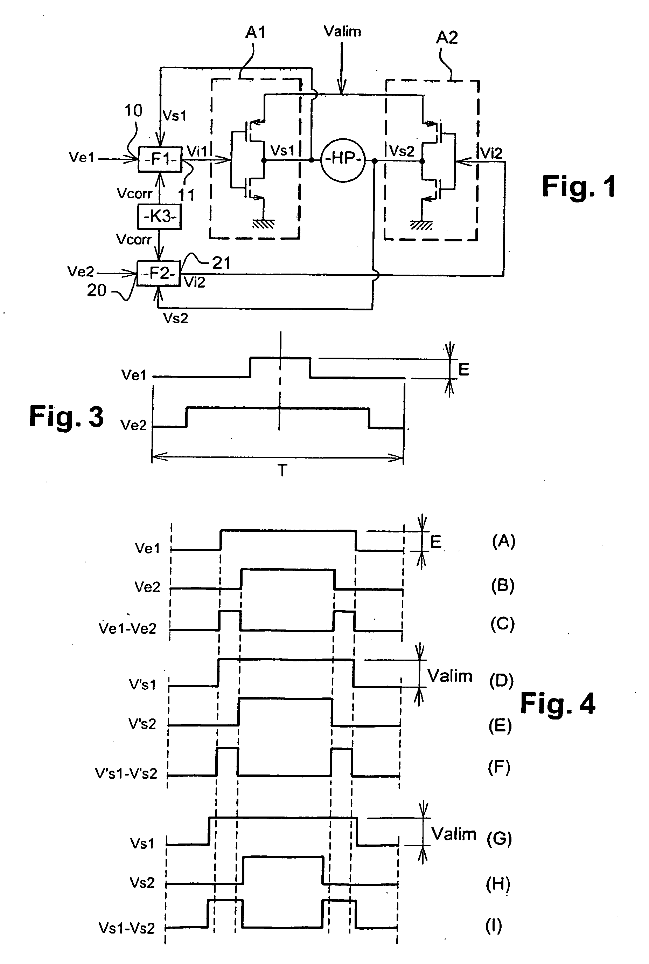

Bien que le générateur de l'invention ne soit pas restreint à cette application comme ceci sera précisé ultérieurement, l'hypothèse sera faite pour l'instant que les signaux d'entrée sont du type illustré à la figure 3.

Le signal d'entrée Ve1 sera donc supposé être constitué par un signal présentant un rapport cyclique modulé à la fréquence de base 1/T et une amplitude calibrée E, la fréquence 1/T étant par exemple de l'ordre de 400 kHz.

Le signal d'entrée Ve2 sera quant à lui supposé être constitué par un signal présentant la même amplitude calibrée E que le signal d'entrée Ve1, un rapport cyclique modulé à la fréquence de base 1/T et complémentaire à 1 du rapport cyclique du signal d'entrée Ve1, et un déphasage de 180 degrés par rapport au premier signal d'entrée Ve1.

Dans ces conditions, les signaux d'entrée Ve1 et Ve2 sont tels que leur somme présente une valeur moyenne constante.

Chacun des circuits de formatage F1 et F2 présente par ailleurs une sortie correspondante 11 ou 21, sur laquelle il délivre un signal intermédiaire correspondant Vi1 ou Vi2 présentant un rapport cyclique modulé à la fréquence de base 1/T.

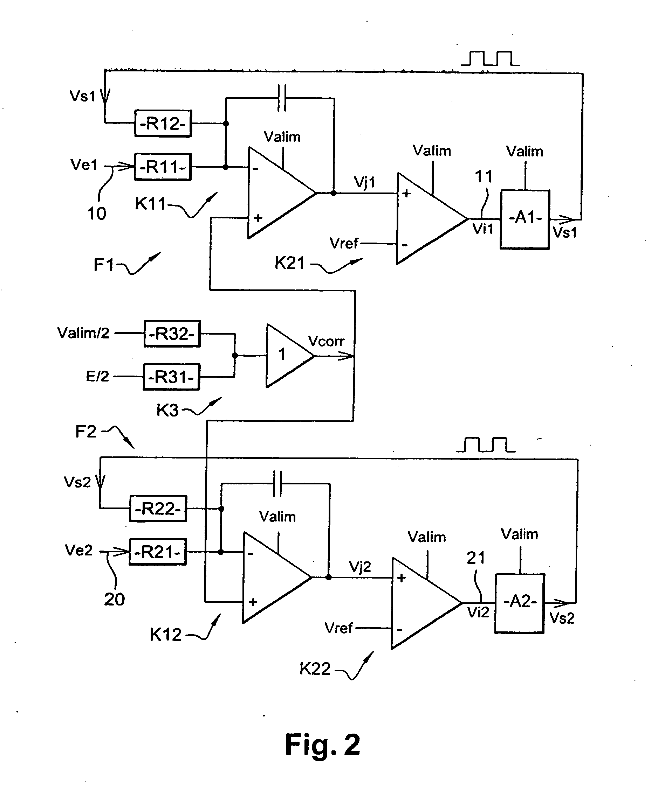

Comme le montre la figure 2, le circuit de formatage F1 comprend d'une part un intégrateur K11 propre à élaborer un signal d'intégration Vj1, et d'autre part un comparateur K21 relié à l'intégrateur K11 et propre à élaborer le signal intermédiaire Vi1 par comparaison du signal d'intégration Vj1 avec un signal de référence Vref.

De même, le circuit de formatage F2 comprend d'une part un intégrateur K12 propre à élaborer un signal d'intégration Vj2, et d'autre part un comparateur K22 relié à l'intégrateur K12 et propre à élaborer le signal intermédiaire Vi2 par comparaison du signal d'intégration Vj2 avec un signal de référence Vref.

L'amplificateur A1 de classe D est alimenté par une tension d'alimentation Valim, est relié à la sortie 11 du circuit de formatage F1, et fournit au transducteur HP, en tant que premier signal de sortie Vs1 du générateur, un signal évoluant en fonction du signal intermédiaire Vi1 et présentant une amplitude liée à la tension d'alimentation Valim.

De même, l'amplificateur A2 de classe D est alimenté par la tension d'alimentation Valim, est relié à la sortie 21 du circuit de formatage F2, et fournit au transducteur HP, en tant que deuxième signal de sortie Vs2 du générateur, un signal évoluant en fonction du signal intermédiaire Vi2 et présentant une amplitude liée à la tension d'alimentation Valim.

Comme le montre la figure 1, les amplificateurs A1 et A2 forment des moitiés respectives symétriques d'un même pont d'amplification de classe D conformé en H.

Comme le montre encore la figure 1, chacun des amplificateurs A1 et A2 est formé de deux transistors MOSFET à types de canaux opposés fonctionnant en interrupteurs, les grilles de ces transistors étant reliées à la sortie du circuit de formatage correspondant, et leurs sources étant reliées au transducteur HP.

Selon l'invention, les signaux d'intégration Vj1 et Vj2 sont élaborés à partir des signaux d'entrée correspondants, Ve1 et Ve2, et des signaux de sortie correspondants Vs1 et Vs2 appliqués en contre-réaction.

Plus précisément, l'intégrateur K11 du circuit F1 est conçu pour intégrer la différence entre deux signaux composites dont le premier est constitué par les signaux d'entrée Ve1 et de sortie Vs1 pondérés par les résistances d'entrée R12 et R11 formant des facteurs d'amplification respectifs.

Le deuxième signal composite, Vcorr, est élaboré par un circuit K3 formé d'un amplificateur suiveur recevant sur son entrée des tensions de décalage E/2 et Valim/2 respectivement égales à la moitié de l'amplitude maximale E des signaux d'entrée Ve1 et Ve2 et à la moitié de la tension d'alimentation Valim, ces tensions de décalage étant pondérées par les résistances d'entrée R32 et R31 formant des facteurs d'amplification respectifs.

De même, l'intégrateur K12 du circuit F2 est conçu pour intégrer la différence entre deux signaux composites dont le premier est constitué par les signaux d'entrée Ve2 et de sortie Vs2 pondérés par les résistances d'entrée R22 et R21 formant des facteurs d'amplification respectifs, et dont le deuxième est constitué par le signal composite Vcorr.

Enfin, le signal de référence Vref fourni à chacun des comparateurs K21 et K22 présente une valeur moyenne égale à la moitié de la tension d'alimentation Valim, c'est-à-dire à Valim/2.

Dans le cas considéré où les signaux d'entrée Ve1 et Ve2 sont des signaux à rapport cyclique modulé tels qu'illustrés à la figure 3, le signal de référence Vref fourni à chacun des comparateurs K21 et K2 est égal à la moitié de la tension d'alimentation Valim, c'est-à-dire à Valim/2.

Les résistances R11, R12, R21 et R22 sont choisies de manière que les circuits de formatage F1 et F2 aient le même gain G en boucle fermée, et sont donc telles que :

$$R12 \ / \ R11 \ = \ R22 \ / \ R21 \ = \ G,$$

le gain G étant choisi comme étant au moins égal à 2 pour assurer la stabilité de ces circuits.

Les signaux Vcorr, Vs1 et Vs2 répondent eux-mêmes aux relations suivantes:

$$Vcorr \ = \ (R31*Valim \ + \ R32*E) \ / \ 2*(R31 \ + \ R32);$$

$$Vs1 \ = \ Valim*(R31/R11)*(R11+R12)/2*(R31+R32) \ +$$
$$(E/2)*[\{(R32/R11)*(R11+R12)/(R31+R32)\}-$$
$$(R12/R11)];$$

$$Vs2 \ = \ Valim*(R31/R21)*(R21+R22)/2*(R31+R32) \ +$$
$$(E/2)*[\{(R32/R21)*(R21+R22)/(R31+R32)\}-$$
$$(R22/R21)].$$

Ainsi, il suffit que R31/R11 = R32/R12 = R31/R21 = R32/R22 = k, où k est un facteur constant non nul, pour que :

$$Vcorr \ = \ (Valim \ + \ G*E) \ / \ 2*(G \ + \ 1);$$

$$Vs1 \ = \ Valim/2;$$

$$Vs2 \ = \ Valim/2.$$

En pratique, le facteur k pourra par exemple être avantageusement choisi comme égal à 1.

Dans ces conditions, les signaux de sortie Vs1 et Vs2, qui présentent en pratique une amplitude égale à Valim, ont un rapport cyclique égal à 0.5 lorsque les signaux d'entrée Ve1 et Ve2 ont eux-mêmes un rapport cyclique égal à 0.5, et les comparateurs K21 et K22 ont leur point de fonctionnement autour de Valim/2.

En résumé, le circuit de formatage F2 est donc équivalent dans sa structure et sa fonction au circuit de formatage F1, utilise le signal de référence Vref et les tensions de décalage E/2 et Valim/2 pondérées pour présenter un rapport d'amplification R32/R31 égal au gain G défini par R12/R11, et applique au second signal d'entrée Ve2, pour l'obtention du second signal intermédiaire Vi2, une fonction de transfert identique à celle que le premier circuit de formatage F1 applique au premier signal d'entrée Ve1 pour l'obtention du premier signal intermédiaire Vi1.

Lorsque le rapport cyclique du signal d'entrée Ve1 est égal à D0 et que la tension d'alimentation est égale à Valim1, le rapport cyclique D11 du signal de sortie Vs1 est égal à :

$$\texttt{D11 = 0.5*[1+E/Valim1*G*(2*D0-1)]}.$$

De même, lorsque le rapport cyclique du signal d'entrée Ve1 est égal à D0 et que la tension d'alimentation est égale à Valim2, le rapport cyclique D12 du signal de sortie Vs1 est égal à :

$$\texttt{D12 = 0.5*[1+E/Valim2*G*(2*D0-1)]}.$$

Il en résulte que:

$$\texttt{Valim1 / Valim2 = (2*D12-1) / (2*D11-1)}.$$

En d'autres termes, les signaux de sortie Vs1 et Vs2, qui sont dans l'hypothèse considérée des signaux mutuellement déphasés de 180 degrés, présentant une même amplitude en pratique égale à la tension d'alimentation Valim, et des rapports cycliques respectifs modulés à la fréquence de base 1/T et complémentaires à 1 l'un de l'autre, sont en outre tels que le rapport cyclique de chacun de ces signaux de sortie Vs1 et Vs2 est égal au rapport cyclique du signal d'entrée correspondant, Ve1 ou Ve2, corrigé de toute éventuelle variation du rapport Valim/E entre l'amplitude de la tension d'alimentation Valim et l'amplitude de la tension calibrée E.

Cette propriété est illustrée aux figures 4A à 4J, dont les deux premières illustrent les signaux d'entrée Ve1 et Ve2.

La figure 4C représente la différence Ve1-Ve2 de ces signaux, c'est-à-dire le signal différentiel qui véhicule l'information de l'énergie à fournir au transducteur HP.

Les figures 4D et 4E représentent les signaux de sortie virtuels Vs1' et Vs2' qui seraient produits à partir des signaux d'entrée Ve1 et Ve2 par les amplificateurs A1 et A2 dans l'hypothèse où les circuits de formatage F1 et F2 fonctionneraient en boucle ouverte.

La figure 4F, qui représente la différence de ces signaux de sortie virtuels, confirme que les rapports cycliques des signaux Vs1' et Vs2' sont alors respectivement identiques aux rapports cycliques des signaux Ve1 et Ve2 quelles que soient les évolutions de la tension d'alimentation Valim.

Les figures 4G et 4H représentent en revanche les signaux de sortie Vs1 et Vs2 réellement produits à partir des signaux d'entrée Ve1 et Ve2 par les amplificateurs A1 et A2 tels que pilotés par les circuits de formatage F1 et F2 fonctionnant en boucle fermée, la tension d'alimentation Valim étant supposée être en déficit par rapport à sa valeur nominale de référence.

Dans ces conditions, et comme le montre la figure 4I qui représente la différence des signaux de sortie réels Vs1 et Vs2, les rapports cycliques de ces signaux Vs1 et Vs2 diffèrent des rapports cycliques des signaux d'entrée Ve1 et Ve2, de sorte qu'ils se trouvent corrigés du déficit de tension d'alimentation, de sorte que le transducteur HP reçoit une quantité d'énergie qui ne dépend que des rapports cycliques des signaux d'entrée Ve1 et Ve2 et d'un facteur d'amplification fixe.

Comme indiqué précédemment, le générateur de l'invention peut traiter d'autres signaux d'entrée que les signaux illustrés à la figure 3.

Ainsi, le premier signal d'entrée Ve1 peut être constitué par un signal sinusoïdal de valeur moyenne égale à la moitié de la tension d'alimentation Valim, c'est-à-dire un signal sinusoïdal superposé à une composante continue égale à Valim/2.

Dans ce cas, le signal de référence Vref est constitué par un signal triangulaire unipolaire lui aussi superposé à une composante continue égale à Valim/2.

Dans le cas où le générateur utilisé comprend deux circuits de formatage et deux amplificateurs et admet donc un deuxième signal d'entrée Ve2, ce dernier est également constitué par un signal sinusoïdal de même amplitude maximale que le premier signal d'entrée Ve1, superposé à une composante continue égale à Valim/2, et déphasé de 180 degrés par rapport au premier signal d'entrée Ve1.

Pour les applications audio, la fréquence du signal sinusoïdal d'entrée est typiquement comprise entre 20 Hz et 20 kHz, le signal de référence triangulaire ayant en théorie une fréquence au moins double de celle du signal sinusoïdal d'entrée, et en pratique une fréquence par exemple de l'ordre de 400 kHz.

**Revendications**

1. Générateur électronique, propre à fournir au moins un premier signal de sortie (Vs1) présentant un rapport cyclique modulé à une fréquence de base (1/T) et notamment adapté à alimenter un transducteur audio (HP), ce générateur comprenant au moins : un premier circuit de formatage (F1) présentant une entrée (10) recevant un premier signal d'entrée (Ve1), et une sortie (11) délivrant un premier signal intermédiaire (Vi1) présentant un rapport cyclique modulé à la fréquence de base (1/T); et au moins un premier amplificateur (A1) de classe D alimenté par une tension d'alimentation (Valim), relié à la sortie (11) du premier circuit de formatage (F1), et fournissant, en tant que premier signal de sortie (Vs1) du générateur, un signal évoluant en fonction du premier signal intermédiaire (Vi1) et d'amplitude liée à la tension d'alimentation (Valim), ledit premier circuit de formatage (F1) comprenant au moins un intégrateur (K11) élaborant un signal d'intégration (Vj1), et un comparateur (K21) élaborant le premier signal intermédiaire (Vi1) par comparaison du signal d'intégration (Vj1) avec un signal de référence (Vref), **caractérisé en ce que** l'intégrateur (KI1) est conçu pour intégrer la différence entre deux signaux composites, **en ce que** l'un des signaux composites est constitué par les premiers signaux d'entrée (Ve1) et de sortie (Vs1) pondérés par des facteurs d'amplification respectifs dont le rapport (R12/R11) correspond à un premier gain (G), **en ce que** l'autre signal composite (Vcorr) est constitué d'une première et d'une seconde tensions de décalage (E/2, Valim/2) respectivement égales à la moitié de l'amplitude maximale (E) du premier signal d'entrée (Ve1) et à la moitié de la tension d'alimentation (Valim), ces tensions de décalage (E/2, Valim/2) étant pondérées par des facteurs d'amplification respectifs dont le rapport (R32/R31) correspond au premier gain (G), et **en ce que** le signal de référence (Vref) fourni au comparateur (K21) présente une valeur moyenne égale à la moitié (Valim/2) de la tension d'alimentation (Valim).

2. Générateur électronique suivant la revendication 1, **caractérisé en ce que** le premier signal d'entrée (Ve1) est un signal sinusoïdal de valeur moyenne égale à la moitié (Valim/2) de la tension d'alimentation (Valim), et **en ce que** le signal de référence (Vref) est un signal triangulaire unipolaire.

3. Générateur électronique suivant la revendication 1, **caractérisé en ce que** le premier signal d'entrée (Ve1) est un signal présentant une amplitude calibrée (E) et un rapport cyclique modulé à la fréquence de base (1/T), et **en ce que** le signal de référence (Vref) est égal à la moitié (Valim/2) de la tension d'alimentation (Valim).

4. Générateur électronique suivant l'une quelconque des revendications précédentes, propre à fournir également un second signal de sortie (Vs2) présentant un rapport cyclique modulé à la fréquence de base (1/T) et notamment adapté à alimenter le transducteur audio (HP) recevant également le premier signal de sortie (Vs1), **caractérisé en ce qu'**il comprend un second circuit de formatage (F2) présentant une entrée (20) recevant un second signal d'entrée (Ve2), et une sortie (21) délivrant un second signal intermédiaire (Vi2) présentant un rapport cyclique modulé à la fréquence de base (1/T); et un second amplificateur (A2) de classe D alimenté par la tension d'alimentation (Valim), relié à la sortie (21) du second circuit de formatage (F2), et fournissant, en tant que second signal de sortie (Vs2) du générateur, un signal évoluant en fonction du second signal intermédiaire (Vi2) et d'amplitude liée à la tension d'alimentation (Valim), **en ce que** ledit second circuit de formatage (F2) est équivalent dans sa structure et sa fonction au premier circuit de formatage (F1), utilise ledit signal de référence (Vref) et lesdites tensions de décalage (E/2, Valim/2) pondérées pour présenter un rapport d'amplification (R32/R31) correspondant audit premier gain (G), et applique au second signal d'entrée (Ve2), pour l'obtention du second signal intermédiaire (Vi2), une fonction de transfert identique à celle que le premier circuit de formatage (F1) applique au premier signal d'entrée (Ve1) pour l'obtention du premier signal intermédiaire (Vi1), **en ce que** les premier et second amplificateurs (A1, A2) forment des moitiés respectives symétriques d'un même pont d'amplification de classe D conformé en H, et **en ce que** la somme des premier et second signaux d'entrée (Ve1, Ve2) présente une valeur moyenne constante.

**5.** Générateur électronique suivant l'ensemble des revendications 3 et 4, **caractérisé en ce que** le second signal d'entrée (Ve2) est un signal présentant la même amplitude calibrée (E) que le premier signal d'entrée (Ve1), un rapport cyclique modulé à la fréquence de base (1/T) et complémentaire à 1 du rapport cyclique du premier signal d'entrée (Ve1), et un déphasage de 180 degrés par rapport au premier signal d'entrée (Ve1), ce dont il résulte que les premier et second signaux de sortie (Vs1, Vs2) sont des signaux mutuellement déphasés de 180 degrés, présentant une même amplitude liée à la tension d'alimentation (Valim), et des rapports cycliques respectifs modulés à la fréquence de base (1/T) et complémentaires à 1 l'un de l'autre, le rapport cyclique de chaque signal de sortie (Vs1, Vs2) étant égal au rapport cyclique du signal d'entrée correspondant (Ve1, Ve2) corrigé de toute éventuelle variation du rapport (Valim/E) entre l'amplitude de la tension d'alimentation (Valim) et l'amplitude de la tension calibrée (E).

**Claims**

**1.** Electronic generator, suitable for supplying at least one first output signal (Vs1) having a duty cycle modulated at a basic frequency (1/T) and notably suitable for supplying an audio transducer (HP), this generator comprising at least: a first formatting circuit (F1) having an input (10) receiving a first input signal (Ve1), and an output (11) delivering a first intermediate signal (Vi1) having a duty cycle modulated at the basic frequency (1/T); and at least one first class D amplifier (A1) powered by a power-supply voltage (Valim), connected to the output (11) of the first formatting circuit (F1), and supplying, as a first output signal (Vs1) of the generator, a signal changing as a function of the first intermediate signal (Vi1) and with an amplitude linked to the power-supply voltage (Valim), the said first formatting circuit (F1) comprising at least one integrator (K11) generating an integration signal (Vj1), and a comparator (K21) generating the first intermediate signal (Vi1) by comparison with the integration signal (Vj1) with a reference signal (Vref), **characterized in that** the integrator (K11) is designed to integrate the difference between two composite signals, **in that** one of the composite signals is constituted by the first input signals (Ve1) and output signals (Vs1) weighted by respective amplification factors, the ratio (R12/R11) of which corresponds to a first gain (G), **in that** the other composite signal (Vcorr) is constituted of a first and of a second offset voltages (E/2, Valim/2) respectively equal to half of the maximum amplitude (E) of the first input signal (Ve1) and to half of the power-supply voltage (Valim), these offset voltages (E/2, Valim/2) being weighted by respective amplification factors, the ratio (R32/R31) of which corresponds to the first gain (G), and **in that** the reference signal (Vref) supplied to the comparator (K21) exhibits a mean value equal to half (Valim/2) of the power-supply voltage (Valim).

**2.** Electronic generator according to Claim 1, **characterized in that** the first input signal (Ve1) is a sine wave signal with a mean value equal to half (Valim/2) of the power-supply voltage (Valim), and **in that** the reference signal (Vref) is a triangular unipolar signal.

**3.** Electronic generator according to Claim 1, **characterized in that** the first input signal (Ve1) is a signal having a calibrated amplitude (E) and a duty cycle modulated at the basic frequency (1/T), and **in that** the reference signal (Vref) is equal to half (Valim/2) of the power-supply voltage (Valim).

**4.** Electronic generator according to any one of the preceding claims, capable of supplying also a second output signal (Vs2) having a duty cycle modulated at the basic frequency (1/T) and notably suitable for powering the audio transducer (HP) also receiving the first output signal (Vs1), **characterized in that** it comprises a second formatting circuit (F2) having an input (20) receiving a second input signal (Ve2), and an output (21) delivering a second intermediate signal (Vi2) having a duty cycle modulated at the basic frequency (1/T); and a second class D amplifier (A2) powered by the power-supply voltage (Valim), connected to the output (21) of the second formatting circuit (F2), and supplying, as a second output signal (Vs2) of the generator, a signal changing as a function of the second intermediate signal (Vi2) and with an amplitude linked to the power-supply voltage (Valim), **in that** the said second formatting circuit (F2) is equivalent in its structure and its function to the first formatting circuit (F1), uses the said reference signal (Vref) and the said offset voltages (E/2, Valim/2) weighted to exhibit an amplification ratio (R32/R31) corresponding to the said first gain (G), and applies to the second input signal (Ve2), in order to obtain the second intermediate signal (Vi2), a transfer function identical to that of the first formatting circuit (F1) applies to the first input signal (Ve1) in order to obtain the first intermediate signal (Vi1), **in that** the first and second amplifiers (A1, A2) form respective symmetrical halves of one and the same class D amplification bridge in H form, and **in that** the sum of the first and second input signals (Ve1, Ve2) has a constant mean value.

**5.** Electronic generator according to both Claims 3 and 4, **characterized in that** the second input signal (Ve2) is a signal having the same calibrated amplitude (E) as the first input signal (Ve1), a duty cycle modulated at the basic frequency (1/T) and 1s complement of the duty cycle of the first input signal (Ve1), and a phase shift of 180 degrees relative to the first input signal (Ve1), from which it results that the first and second output signals (Vs1, Vs2) are signals that are mutually phase-shifted by 180 degrees, having one and the same amplitude linked to the power-supply voltage (Valim), and respective duty cycles modulated at the basic frequency (1/T) and 1s complement of one another, the duty cycle of each output signal (Vs1, Vs2) being equal to the duty cycle of the corresponding input signal (Ve1, Ve2) corrected of any possible variation of the ratio (Valim/E) between the amplitude of the power-supply voltage (Valim) and the amplitude of the calibrated voltage (E).

**Patentansprüche**

1. Elektronischer Signalgeber, der zumindest ein erstes Ausgangssignal (Vs1) mit einem auf eine Basisfrequenz modulierten Tastverhältnis (1/T) ausgeben kann und insbesondere zum Versorgen eines Audiowandlers (HP) ausgelegt ist, wobei dieser Signalgeber aufweist: zumindest ein erstes Formatierungsglied (F1) mit einem Eingang (10), der ein erstes Eingangssignal (Ve1) empfängt, und mit einem Ausgang (11), der ein erstes Zwischensignal (Vi1) mit einem auf die Basisfrequenz modulierten Tastverhältnis (1/T) ausgibt; und zumindest einen ersten D-Verstärker (A1), der mit einer Versorgungsspannung (Valim) gespeist wird, mit dem Ausgang (11) des ersten Formatierungsglieds (F1) verbunden ist und als erstes Ausgangssignal (Vs1) des Signalgebers ein Signal liefert, das sich in Abhängigkeit von dem ersten Zwischensignal (Vi1) und einer an die Versorgungsspannung (Valim) gebundenen Amplitude ändert, wobei das erste Formatierungsglied (F1) zumindest einen Integrator (K11) umfasst, der ein Integrationssignal (Vj1) verarbeitet, sowie einen Komparator (K21), der das erste Zwischensignal (Vi1) durch Vergleich des Integrationssignals (Vj1) mit einem Referenzsignal (Vref) verarbeitet, **dadurch gekennzeichnet, dass** der Integrator (K11) darauf ausgelegt ist, die Differenz zwischen zwei zusammengesetzten Signalen zu integrieren, dass eines der zusammengesetzten Signale aus dem ersten Eingangs- (Ve1) und Ausgangssignal (Vs1) besteht, die mit jeweiligen Verstärkungsfaktoren gewichtet sind, deren Verhältnis (R12/R11) einem ersten Verstärkungsgrad (G) entspricht, dass das andere zusammengesetzte Signal (Vcorr) aus einer ersten und einer zweiten Offsetspannung (E/2, Valim/2) besteht, die gleich der halben maximalen Amplitude (E) des ersten Eingangssignals (Ve1) bzw. der halben Versorgungsspannung (Valim) sind, wobei diese Offsetspannungen (E/2, Valim/2) mit jeweiligen Verstärkungsfaktoren gewichtet sind, deren Verhältnis (R32/R31) dem ersten Verstärkungsgrad (G) entspricht, und dass das dem Komparator (K21) zugeführte Referenzsignal (Vref) einen Mittelwert aufweist, der gleich der Hälfte (Valim/2) der Versorgungsspannung (Valim) ist.

2. Elektronischer Signalgeber nach Anspruch 1, **dadurch gekennzeichnet, dass** das erste Eingangssignal (Ve1) ein Sinussignal mit einem Mittelwert gleich der Hälfte (Valim/2) der Versorgungsspannung (Valim) ist und dass das Referenzsignal (Vref) ein einpoliges Dreiecksignal ist.

3. Elektronischer Signalgeber nach Anspruch 1, **dadurch gekennzeichnet, dass** das erste Eingangssignal (Ve1) ein Signal mit einer kalibrierten Amplitude (E) und einem auf die Basisfrequenz modulierten Tastverhältnis (1/T) ist und dass das Referenzsignal (Vref) gleich der Hälfte (Valim/2) der Versorgungsspannung (Valim) ist.

4. Elektronischer Signalgeber nach irgendeinem der vorangehenden Ansprüche, wobei er ebenso ein zweites Ausgangssignal (Vs2) mit einem auf die Basisfrequenz modulierten Tastverhältnis (1/T) ausgeben kann und insbesondere zum Versorgen des Audiowandlers (HP) ausgelegt ist, der auch das erste Ausgangssignal (Vs1) empfängt, **dadurch gekennzeichnet, dass** er ein zweites Formatierungsglied (F2) mit einem ein zweites Eingangssignal (Ve2) empfangenden Eingang (20) und mit einem Ausgang (21) aufweist, der ein zweites Zwischensignal (Vi2) mit einem auf die Basisfrequenz modulierten Tastverhältnis (1/T) ausgibt; sowie einen zweiten D-Verstärker (A2), der mit der Versorgungsspannung (Valim) gespeist wird, mit dem Ausgang (21) des zweiten Formatierungsglieds (F2) verbunden ist und als zweites Ausgangssignal (Vs2) des Signalgebers ein Signal liefert, das sich in Abhängigkeit von dem zweiten Zwischensignal (Vi2) und einer an die Versorgungsspannung (Valim) gebundenen Amplitude ändert, dass das zweite Formatierungsglied (F2) in seiner Struktur und seiner Funktion zu dem ersten Formatierungsglied (F1) äquivalent ist, das Referenzsignal (Vref) und die gewichteten Offsetspannungen (E/2, Valim/2) dazu benutzt, ein Verstärkungsverhältnis (R32/R31) bereitzustellen, das dem ersten Verstärkungsgrad (G) entspricht, und zum Erhalten des zweiten Zwischensignals (Vi2) auf das zweite Eingangssignal (Ve2) eine Übertragungsfunktion anwendet, die zu derjenigen identisch ist, die das erste Formatierungsglied (F1) auf das erste Eingangssignal (Ve1) zum Erhalten des ersten Zwischensignals (vi1) anwendet, dass der erste und der zweite Verstärker (A1, A2) jeweils symmetrische Hälften einer gleichen H-förmig gebildeten D-Verstärkungsbrücke bilden, und dass die Summe des ersten und zweiten Eingangssignals (Ve1, Ve2) einen konstanten Mittelwert aufweist.

**5.** Elektronischer Signalgeber nach Anspruch 3 und 4 zusammengenommen, **dadurch gekennzeichnet, dass** das zweite Eingangssignal (Ve2) ein Signal ist, das die gleiche kalibrierte Amplitude (E) wie das erste Eingangssignal (Ve1), ein auf die Basisfrequenz moduliertes Tastverhältnis (1/T), das komplementär zu 1 des Tastverhältnisses und des ersten Eingangssignals (Ve1) ist, und eine Phasenverschiebung von 180° bezüglich des ersten Eingangssignals (Ve1) aufweist, woraus sich ergibt, dass das erste und das zweite Ausgangssignal (Vs1, Vs2) um 180° zueinander phasenverschobene Signale sind, die eine gleiche an die Versorgungsspannung (Valim) gebundene Amplitude und jeweilige auf die Basisfrequenz modulierte Tastverhältnisse (1/T) aufweisen, die gegenseitig komplementär zu 1 sind, wobei das Tastverhältnis eines jeden Ausgangssignals (Vs1, Vs2) gleich dem Tastverhältnis des entsprechenden Eingangssignals (Ve1, Ve2) ist, das bezüglich jeglicher eventuellen Schwankung im Verhältnis (Valim/E) zwischen der Amplitude der Versorgungsspannung (Valim) und der Amplitude der kalibrierten Spannung (E) korrigiert ist.

**Fig. 1**

**Fig. 3**

**Fig. 4**

**Fig. 2**